# EUROPEAN PATENT APPLICATION

(11) **EP 2 940 183 A1**
(43) Date of publication of application: **04.11.2015**
(21) Application number: 13868944.3
(22) Date of filing: 12.12.2013
(51) Int. Cl.: C23C 16/458, C23C 16/44, C23C 16/503

(54) **IN-LINE PLASMA CVD DEVICE**

(30) Priority: 26.12.2012 JP 2012282954
(71) Applicant: Kabushiki Kaisha Kobe Seiko Sho (Kobe Steel, Ltd.), Kobe-shi, Hyogo 651-8585 (JP)
(72) Inventor: TAMAGAKI, Hiroshi, Takasago-shi, Hyogo 676-8670 (JP); HAGA, Junji, Takasago-shi, Hyogo 676-8670 (JP)
(74) Representative: TBK
(86) International application number: PCT/JP2013/007338
(87) International publication number: WO 2014/103228

(57) **Abstract**

Provided is an in-line plasma CVD apparatus (100) capable of performing a deposition process at a high production efficiency while maintaining stable deposition conditions, without spending time and energy on cleaning and the like even when in use for a long time. This plasma CVD apparatus (100) is equipped with a deposition chamber (1) and load-lock chambers (20, 30) which are separate from the deposition chamber (1). The apparatus (100) is of the in-line-type for conveying a substrate between these chambers and producing a film on the substrate. The deposition chamber (1) is equipped with a vacuum chamber (2), a vacuum exhaust means (3) for discharging the air inside the vacuum chamber (2), a gas supply unit (9) for supplying a source gas into the vacuum chamber (2), and a plasma generation power supply (10) for generating plasma inside the vacuum chamber (2). Substrates in the deposition chamber (1) are divided into a first group (18) connected to one pole of the plasma generation power supply (10), and a second group (19) connected to the other pole of the plasma generation power supply (10). The plasma is produced between the first group (18) and the second group (19) which have different polarities from one another.

## Description

### TECHNICAL FIELD

The present invention relates to a plasma CVD apparatus for forming a CVD coating on a substrate, and more particularly, to an in-line plasma CVD apparatus with a high production efficiency while maintaining stable deposition conditions.

### BACKGROUND ART

Engine parts, etc., of automotives, such as a piston ring, are required to have good wear resistance, heat resistance, seizure resistance, and the like. For this reason, these mechanical parts are subjected to a wear-resistant coating, such as a diamond-like-carbon (DLC), by using a plasma CVD method.

When forming the coating on the above-mentioned substrate by the plasma CVD method, numerous substrates are preferably accommodated in a vacuum chamber and coated at one time in terms of productivity. In order to process the numerous substrates at one time in this way, the coatings formed on the respective substrates have to have uniform thickness and film properties among the substrates. Thus, in a conventional plasma CVD apparatus, a plurality of substrates is arranged on the same table. The substrates undergo the deposition process while being rotated and revolved by driving the table.

Alternatively, from another viewpoint of improving the productivity, a so-called in-line type apparatus, or an apparatus equipped with a load-lock chamber is employed. Such an apparatus includes a deposition chamber, and a chamber dedicated to evacuation or the like and separately provided from the deposition chamber. The substrates are conveyed between these chambers. In this way, a number of deposition cycles are performed with the deposition chamber constantly maintained under vacuum.

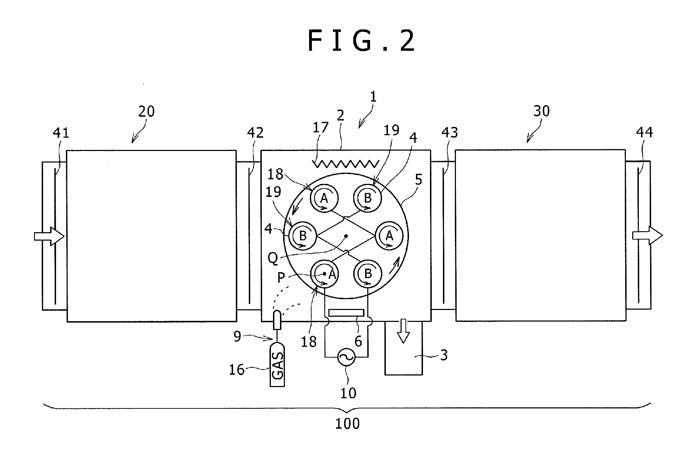

Japanese Unexamined Patent Application Publication No. H5-295551 (Patent Document 1) discloses a modified technique for an in-line plasma CVD apparatus that deposits a coating on a surface of an object to be processed (substrate, base) by the plasma CVD method. Fig. 2 in Patent Document 1 discloses a typical example of the in-line plasma CVD apparatus in the related art. Referring to Fig. 2 and its explanation, the in-line plasma CVD apparatus includes a plurality of independent chambers (compartments) partitioned from each other. In the respective chambers, respective steps of a deposition procedure, which includes evacuation and heating of the substrate, deposition, and exposure to the atmosphere, are individually carried out. The substrates are sequentially conveyed within the apparatus, whereby a coating formation process is performed.

In the in-line plasma CVD apparatus, the respective stages of the process are performed in compartments independent from each other. Thus, the in-line plasma CVD apparatus can be expected to have high productivity, and to stably form a coating of high quality with no gaseous adsorption in the inside of the deposition chamber while not needing exposure of the deposition chamber to the atmosphere every time each substrate is inserted into the deposition chamber. Note that Patent Document 1 discloses the technique of the in-line plasma CVD apparatus in which an atmospheric heating furnace is provided to preheat the substrate under atmospheric pressure, thereby shortening a temperature rise time for increasing the temperature of the substrate up to a predetermined temperature in the load chamber.

In apparatuses that form a coating by the plasma CVD method, the coating is deposited not only a substrate to be coated, but also walls of a deposition chamber, electrodes facing the substrate, and the like. In particular, a part serving as an electric current passage for generating a plasma tends to be covered with the coating. The substrate to be coated and a jig supporting the substrate are removed after completion of the deposition process, and then the substrate is replaced by a next object to be coated. However, the walls of the deposition chamber and the electrodes or the like facing the substrate are used through multiple processes, so that the coating deposited thereon becomes thicker as the deposition cycle is repeated.

For example, in the deposition apparatus disclosed in Patent Document 1, while a high-frequency electrode denoted by reference numeral 30 in Fig. 2 of Patent Document 1 is opposed to the substrate mounted on a substrate cart denoted by reference numeral 1, a plasma is generated by applying a high-frequency power to the high-frequency electrode. Thus, the coating is formed on the substrate and simultaneously the coating is also deposited on the high-frequency electrode in the substantially same amount as that of the coating on the substrate. Although the substrate cart and the substrate are replaced by new ones every completion of the deposition cycle, the high-frequency electrode is constantly used, so that the coating is continuously deposited on the electrode. The coating deposited thick in this way tends to be peeled off and fly apart, which can result in a defective coating. Such deposits therein need to be removed by cleaning on a regular basis.

Further, when the coating deposited by the plasma CVD method is an insulating coating, such as a DLC, other problems can also be caused. That is, as the deposition progresses to thicken the coating, the insulating coating can include a resistance component acting on supply of electric power. Thus, even if the same power conditions are set, the state of generation of the plasma disadvantageously fluctuates, and thus the properties of the coating are also varied.

As another system of the plasma CVD apparatus, there is proposed a system in which a part of the high-frequency electrode is simply a wall of a chamber and an electric power is applied to a substrate and a substrate cart. Even in this system, however, the coating is also deposited on the chamber wall opposed to the substrate as well as on the substrate. As a result, there arises a problem that the deposits attached thickly might fly apart. When the formed coating is insulating, the coating positioned even on the chamber side exist at the part through which the electric power passes, resulting in an increase in electric resistance of the inner wall of the chamber. Thus, the generation of the plasma that would occur with an inner wall of the chamber serving as one electrode becomes unstable, or process requirements can deviate from the optimal ones.

### CITATION LIST

### PATENT DOCUMENT

Patent Document 1: JPH 05-295551 A

### SUMMARY OF THE INVENTION

Accordingly, it is an object of the present invention to provide an in-line plasma CVD apparatus with a high production efficiency that is less likely to deposit a CVD coating on a part other than a substrate, thereby being capable of stably performing its operation without cleaning for a long time.

The in-line plasma CVD apparatus provided by the present invention includes a deposition chamber and a compartment other than the deposition chamber. A substrate is conveyed between the deposition chamber and the compartment. The deposition chamber includes a vacuum chamber, a pump for exhausting the air from the vacuum chamber, a gas supply unit for supplying a source gas into the vacuum chamber, and an AC plasma generation power supply for generating a plasma in the source gas supplied into the vacuum chamber. In the deposition chamber, the substrates are divided or classified into two groups. Specifically, the substrates belong to either a first group which is connected to one pole of the plasma generation power supply, or a second group which is connected to the other pole of the plasma generation power supply.

### BRIEF DESCRIPTION OF DRAWINGS

[Fig. 1] Fig. 1 is a perspective view showing an entire structure of an in-line plasma CVD apparatus according to a first embodiment of the invention.
[Fig. 2] Fig. 2 is a plan view of the in-line plasma CVD apparatus shown in Fig. 1.
[Fig. 3A] Fig. 3A is a perspective view showing an example in which a substrate is set on a rotation table of the plasma CVD apparatus.
[Fig. 3B] Fig. 3B is a perspective view showing another example in which a substrate is set on the rotation table of the plasma CVD apparatus.
[Fig. 4A] Fig. 4A is a plan view for explaining operation states of the in-line plasma CVD apparatus shown in Fig. 1.
[Fig. 4B] Fig. 4B is a side view for explaining operation states of the in-line plasma CVD apparatus shown in Fig. 1.
[Fig. 5A] Fig. 5A is a plan view showing an entire structure of an in-line plasma CVD apparatus according to a second embodiment of the invention.
[Fig. 5B] Fig. 5B is a perspective view of a table trolley and substrate tables.
[Fig. 5C] Fig. 5C is a side view of the table trolley and the substrate tables.
[Fig. 5D] Fig. 5D is a plan view of the table trolley and the substrate tables.
[Fig. 6A] Fig. 6A is a plan view showing an entire structure of an in-line plasma CVD apparatus according to a third embodiment of the invention.
[Fig. 6B] Fig. 6B is a perspective view of a substrate holder used in the in-line plasma CVD apparatus according to the third embodiment of the invention.
[Fig. 7] Fig. 7 is a plan view showing an entire structure of an in-line plasma CVD apparatus according to a fourth embodiment of the invention.
[Fig. 8A] Fig. 8A is a plan view showing an entire structure of an in-line plasma CVD apparatus according to a fifth embodiment of the invention.
[Fig. 8B] Fig. 8B is a perspective view of substrates arranged in the form of multilayer.
[Fig. 8C] Fig. 8C is a plan view of substrate holders arranged in the form of multilayer.
[Fig. 9] Fig. 9 is a plan view showing an entire structure of an in-line plasma CVD apparatus according to a sixth embodiment of the invention.
[Fig. 10A] Fig. 10A is a plan view showing an entire structure of an in-line plasma CVD apparatus according to a seventh embodiment of the invention.
[Fig. 10B] Fig. 10B is another plan view showing the entire structure of the in-line plasma CVD apparatus according to the seventh embodiment of the invention.
[Fig. 10C] Fig. 10C is a perspective view of a partition plate and a table according to the seventh embodiment of the invention.

### DESCRIPTION OF EMBODIMENTS

Now, some embodiments of an in-line plasma CVD apparatus 100 according to the present invention (hereinafter simply referred to as a "plasma CVD apparatus 100") will be described in detail based on the accompanying drawings. Here, the term "in-line type" as used herein is a generic name for an apparatus system with a mechanism that includes a load-lock chamber (pre-evacuation chamber). The mechanism constantly maintains a deposition chamber in a vacuum state, also at the time of replacement of substrates, by exchanging the substrate between an area outside the apparatus (atmospheric pressure) and the deposition chamber (vacuum pressure) via the load-lock chamber. The in-line type includes a load-lock type, an inter-back type, and a multi-chamber type. The object to be coated by the plasma CVD apparatus 100 is a substrate W.

### <First Embodiment>

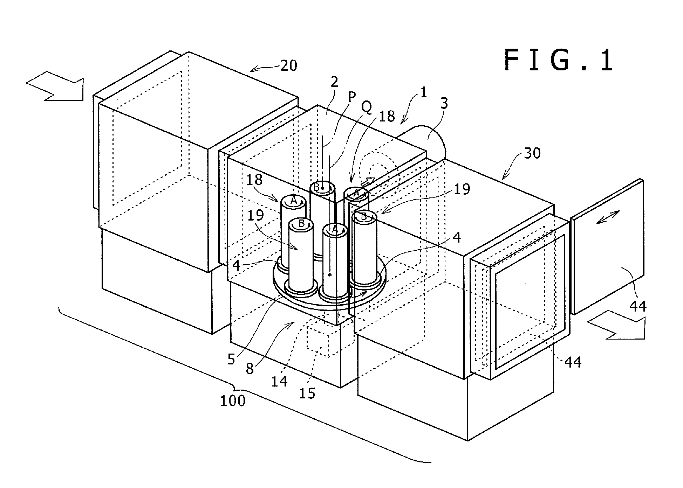

Fig. 1 is a perspective view showing an entire structure of a plasma CVD apparatus 100 according to a first embodiment of the invention, and Fig. 2 is a top view thereof.

The plasma CVD apparatus 100 includes a deposition chamber 1 with a plasma CVD mechanism, a load-lock chamber 20 which is another compartment disposed on an upstream side of the deposition chamber 1, and a load-lock chamber (compartment) 30 which is a further compartment disposed on a downstream side of the deposition chamber 1. The terms "upstream" and "downstream" as used herein are based on the transport direction of the substrate W. At an inlet of the load-lock chamber 20, an isolation valve 41 is placed. An isolation valve 42 is placed between an outlet of the load-lock chamber 20 and an inlet of the deposition chamber 1. An isolation valve 43 is placed between an outlet of the deposition chamber 1 and an inlet of the load-lock chamber 30. An isolation valve 44 is placed at an outlet of the load-lock chamber 30. Fig. 1 illustrates only the isolation valve 44, while as shown in Fig. 2, the plasma CVD apparatus 100 is provided with the four isolation valves 41 to 44 (in other words, isolation doors 41 to 44).

These isolation valves 41 to 44 are closed, whereby the deposition chamber 1, the load-lock chamber 20, and the load-lock chamber 30 are interrupted from the adjacent chamber or atmosphere. That is, by closing the isolation valve, the transfer of the atmosphere or the pressure can be interrupted between the adjacent chambers. On the other hand, by opening the isolation valve, the substrate W independently, or the substrate W mounted on the substrate table can be transported between the adjacent chambers. Figs. 1 and 2 illustrate an example in which the substrate W is transported while being mounted on the substrate table.

The substrates W are divided into two groups. In at least the deposition chamber 1, a vacuum chamber 2 to be described later is grounded, so that both the groups are insulated from the vacuum chamber 2, and are also insulated from each other. Therefore, the respective groups can have potentials independent from each other. These will be described in detail below.

The load-lock chamber 20 includes the isolation valve 41 serving as a door for carrying in the substrate W, and an evacuation mechanism. While the isolation valve 41 is opened (with the isolation valve 42 closed at this time) and exposed to the atmosphere, the substrates W and the substrate table are carried from the outside of the plasma CVD apparatus 100 into the load-lock chamber 20. Thereafter, the isolation valve 41 is closed (with the isolation valve 42 kept closed at this time), so that the inside of the load-lock chamber 20 can be exhausted to vacuum. Once a pretreatment including heating is completed with the inside of the load-lock chamber 20 being under vacuum, then the isolation valve 42 located between the load-lock chamber and the deposition chamber 1 previously evacuated is opened (with the isolation valves 41 and 43 closed at this time), and the substrates W and the substrate table are transported to the deposition chamber 1 under vacuum. The plasma CVD apparatus 100 includes a transport mechanism for transporting the substrates W and the substrate table between the chambers.

After completion of the transport, the isolation valve 42 is closed, followed by introducing the atmospheric air into the load-lock chamber 20, so that the inside of the load-lock chamber 20 is at atmospheric pressure. In this way, substrates W of a next lot and another substrate table can be received.

As shown in Figs. 1 and 2, the deposition chamber 1 includes a vacuum chamber 2, a vacuum pump 3 serving as a vacuum exhaust means for evacuating the vacuum chamber 2, a gas supply unit 9 for supplying source gas to the vacuum chamber 2 evacuated by the vacuum pump 3, and an AC (alternating-current) power supply type plasma generation power supply 10 that generates a plasma in a process gas supplied into the vacuum chamber 2. In the deposition chamber 1, two groups of substrates W are respectively connected to both electrodes of the plasma generation power supply 10. A glow discharge is generated by applying a voltage between the two groups of substrates W, thereby forming a coating. The load-lock chamber 30 on the downstream side is connected to the deposition chamber 1 via the isolation valve 43.

The load-lock chamber 30 includes the isolation valve 44 serving as a door for carrying out the substrate W, and an evacuation mechanism. After the inside of the load-lock chamber 30 is exhausted to vacuum with the isolation valve 44 closed, the isolation valve 43 is opened, whereby the substrate W on which the coating is formed under vacuum in the deposition chamber 1 and the substrate table can be carried from the deposition chamber 1 into the load-lock chamber 30. Then, the isolation valve 43 is closed, so that the deposition chamber 1 is brought into a standby state for the carry-in operation of the substrate W and the substrate table from the load-lock chamber 20 again.

After the isolation valve 43 is closed, a postprocessing including cooling is performed with the load-lock chamber 30 being under vacuum. If the postprocessing is completed, then the atmospheric air is introduced into the load-lock chamber 30. Once the inside of the load-lock chamber 30 reaches the atmospheric pressure, the isolation valve 44 is opened (with the isolation valve 43 closed at this time). In this way, the substrates W and the substrate table, which are exposed to the atmosphere, are carried from the load-lock chamber 30 out to the outside of the plasma CVD apparatus 100. The plasma CVD apparatus 100 includes the transport mechanism for transporting the substrates W and the substrate table between the chambers.

Thereafter, the isolation valve 44 is closed and the inside of the load-lock chamber 30 is exhausted to vacuum. In this way, the load-lock chamber 30 is brought into a state capable of receiving a next substrate W of another lot and another substrate table therefor from the deposition chamber 1.

The above-mentioned structure of the plasma CVD apparatus 100 according to the first embodiment is the same as that of the normal so-called in-line deposition apparatus except that an AC power is applied to the substrates W divided into two groups, which is the feature of the present invention as will be described later. Thus, the plasma CVD apparatus 100 also has the advantages, which are general merits of the in-line deposition apparatus, specifically, that there are few chances for the deposition chamber to be exposed to the atmosphere, enabling the stable coating, and that the mass production can be achieved because of a short tact time. In addition, the plasma CVD apparatus 100 has overcome disadvantages of the general in-line deposition apparatus by refining the structure of the deposition chamber 1. Specifically, the disadvantages are that the deposition chamber 1 sandwiched between the load-lock chamber 20 and the load-lock chamber 30 has to be purposely exposed to the atmosphere in order to clean or remove the coating deposited on the inner wall surface of the deposition chamber 1 that is hardly exposed to the atmosphere. Next, a description will be given of the detailed structure of the deposition chamber 1 in the plasma CVD apparatus 100.

The structure of the deposition chamber 1 in the plasma CVD apparatus 100 will be described below using Figs. 1 to 4B.

The vacuum chamber 2 is a casing capable of having its internal space sealed from the outside air. The vacuum pump 3 is provided on a side surface of the vacuum chamber 2, and serves to exhaust gas from the vacuum chamber 2 into the outside environment to bring the inside of the vacuum chamber 2 into a low-pressure state. The vacuum pump 3 can decompress the inside of the vacuum chamber 2 into the vacuum state.

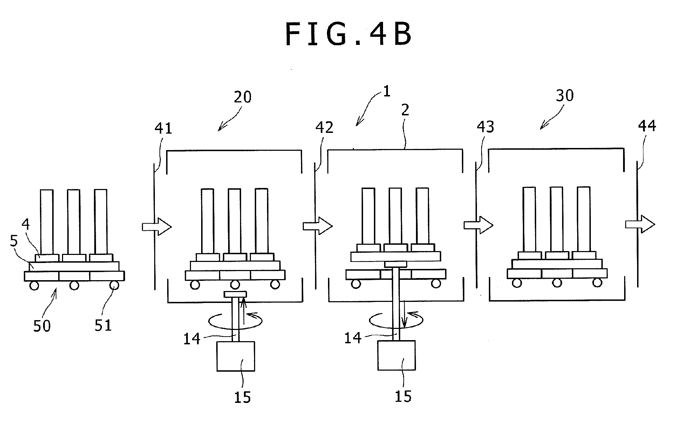

The plasma CVD apparatus 100 further includes the substrate table. The substrate table is capable of mounting a plurality of substrates W thereon, so that these substrates W can be processed within the vacuum chamber 2 while being mounted on the substrate table. The substrate table has a mechanism that performs planetary rotation, that is, rotation and revolution of the substrate W mounted on the substrate table. Specifically, as shown in Fig. 4B, the substrate table of the present embodiment includes six rotation tables 4, and a revolution table 5 mounting thereon these rotation tables 4.

The substrate table can be transported using a table trolley 50. The table trolley 50 is a transportation mechanism for transporting the substrates W together with the substrate table, and includes a plurality of wheels 51. The substrate table can horizontally move within the plasma CVD apparatus 100, while being mounted on the table trolley 50. The table trolley 50 in the first embodiment is sequentially moved from the outside of the plasma CVD apparatus 100 to the load-lock chamber 20, from the load-lock chamber 20 to the deposition chamber 1, from the deposition chamber 1 to the load-lock chamber 30, and from the load-lock chamber 30 to the outside of the plasma CVD apparatus 100.

While the table trolley 50 is stopped at the center of the deposition chamber 1, a rotation introducing mechanism provided under the deposition chamber 1 is connected to the table trolley 50. The rotation introducing mechanism includes a shaft 14 and a rotation driving portion 15 as shown in Fig. 4B. The rotation driving portion 15 rotatably drives the shaft 14 and the revolution table 5 of the substrate table coupled to the shaft. The planetary rotation mechanism incorporated in the substrate table rotates the rotation table 4 on the revolution table 5 while revolving these tables.

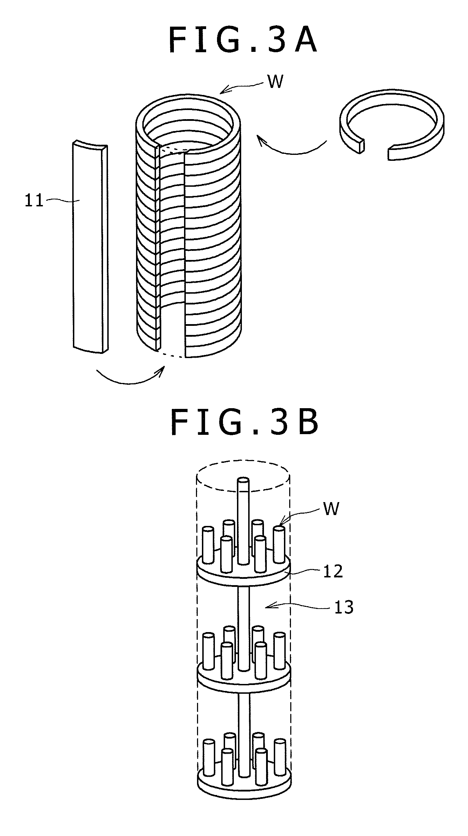

The substrate W subjected to deposition by the plasma CVD apparatus 100 of the first embodiment is preferably installed in a cylindrical space elongated vertically so as to enable the uniform deposition. For example, if the substrate W is a piston ring shown in Fig. 3A, the coating can be non-uniformly deposited on the substrate W as it is. As shown in Fig. 3A, when a part in a peripheral direction of the piston ring is missing and other ring parts cannot form a completely cylindrical shape even by being stacked on each other, an opening of the missing part is closed by a cover 11 as needed, thereby enabling uniform deposition.

When the substrates W to be coated are small-sized members (for example, small piston pins) as shown in Fig. 3B, a mounting jig 13 shown in the figure is preferably used. The mounting jig 13 includes a plurality of disks 12 arranged vertically, and has its entire shape within a cylindrical space. The substrates W are mounted on the respective disks 12, and thus can be stacked vertically in multiple stages.

Even when the substrate W has a shape other than the above-mentioned shape, preferably, a fixing jig corresponding to the shape may be manufactured as appropriate, and the jig and the substrates may be accommodated in the cylindrical space.

An assembly of the substrates W shown in Figs. 3A and 3B is sometimes called a substrate set (work set). As will be described later, the substrates W are assigned to either a first group 18 connected to one pole of the plasma generation power supply 10, or a second group 19 connected to the other pole thereof, every substrate set.

The rotation table 4 is, for example, a circular mounting stand having a flat upper surface. The rotation table 4 holds the substrate W disposed on its upper surface or at an upper part thereof while rotating the substrate W on its rotary axis. The rotation table 4 can be power-fed, and the voltage supplied is also applied to the substrates W.

The substrate table of the plasma CVD apparatus 100 shown in Figs. 1, 2, and 4B includes six rotation tables 4 in total. These six rotation tables 4 are disposed on the revolution table 5 so as to be arranged on one circle in the planar view.

On the other hand, as shown in Figs. 1, 2, 4A, and 4B, the gas supply unit 9 for supplying a process gas including a source gas into the vacuum chamber 2 is provided in the vacuum chamber 2. The gas supply unit 9 serves to supply the source gas required for formation of a CVD coating, and an assist gas for assisting deposition, from a cylinder 16 into the vacuum chamber 2 by a predetermined amount.

For example, when a carbon-based CVD coating, such as a DLC (diamond-like-carbon, amorphous carbon film), is deposited, a source gas including a carbon hydride (acetylene, ethylene, methane, ethane, benzene, toluene, etc.) is used as a process gas. Further, an inert gas, such as argon or helium, may be added as an assist gas as needed. When a silicon oxide-based CVD coating (e.g., SiOₓ film, SiOC film, SiNₓ film, SiCN film) is deposited, a reaction gas, such as oxygen, nitrogen, or ammonia, is added to the source gas containing silicon, such as a silicon organic compound (monosilane, TMS, TEOS, HMDSO etc.), or silane. Further, an inert gas, such as argon, can be added as an assist gas in use as needed. The CVD coatings can include, in addition to those described above, a TiOₓ film, an AlOₓ film, an AlN film, and the like.

A small amount of an additional source gas is sometimes mixed into the main source gas. For example, when forming the DLC coating, a small amount of a silicon-based organic compound gas is added to the source gas mainly containing carbon hydride, so that a coating containing Si can be formed in the DLC. Alternatively, when forming the DLC coating, a small amount of the source gas containing metal (e.g., TTIP (titanium isopropoxide), TDMAT (tetrakis (dimethylamino) titanium)) is added to the source gas mainly containing carbon hydride, so that a coating containing metal (e.g., titanium) can be formed in the DLC.

These source gas, reaction gas, and assist gas can be used in combination as appropriate, depending on the kinds of the gases used.

Now, a description will be given of the characteristic structure of the deposition chamber 1 of the plasma CVD apparatus 100 in the first embodiment, specifically, the plasma generation power supply 10, as well as the supply of power from the plasma generation power supply 10 to the substrate W.

The plasma generation power supply 10 is used to generate the glow discharge in the process gas supplied into the vacuum chamber 2, thereby producing a plasma. The plasma generation power supply 10 supplies an AC power. Examples of the AC power supplied by the plasma generation power supply 10 may include not only an AC power that changes a current or voltage positively and negatively according to a sine waveform, but also an AC power with a square wave that switches between the positive and negative according to a pulsed waveform. The AC for use can also be one including alternating continuous pulse groups with the same polarity, or one formed by superimposing the square wave on the sine-wave AC. In fact, a voltage waveform during generation of the plasma is sometimes distorted due to the influence of the generated plasma. Once the plasma is generated, the zero level of the AC voltage is shifted. When the potential with respect to the ground potential of each electrode is measured, it is observed in many cases that 80 to 95% of the applied voltage is assigned to the negative electrode, and 5 to 20% of the applied voltage is assigned to the positive electrode.

The frequency of the AC current supplied from the plasma generation power supply 10 is preferably in a range of 1 kHz to 100 MHz. When the frequency of the AC current is less than 1 kHz, the charge-up of the coating tends to occur. On the other hand, when the frequency of the AC current exceeds 100 MHz, it is difficult to execute the electric-power feed to the inside of the chamber. In particular, the frequency is preferably in a range of 10 kHz to 400 kHz from the viewpoint of easiness to supply the power to the substrate W, further availability of the power supply, and the like. Especially, when there is provided a rotation and revolution mechanism of the substrate W, the frequency of the AC current is preferably in a range of 1 kHz to 1 MHz. When the frequency is less than 1 kHz, the charge-up of the coating tends to occur. Further, it is difficult to establish a mechanism that transmits the power with a frequency of more than 1 MHz, to the rotating and revolving substrate W. Taking into consideration the availability of the power supply or the like, the frequency of the AC current is more preferably in a range of 10 kHz to 400 kHz. An AC voltage supplied from the plasma generation power supply 10 is preferably in a range of 300 to 3000 V required for maintaining the glow discharge as a wave crest value. The AC power supplied from the plasma generation power supply 10 is varied depending on a superficial area of the substrate W. However, a power per unit area preferably has a power density of about 0.05 to 5 W/cm².

A glow discharge is generated between the electrodes by applying the AC current with the frequency, voltage, and power (power density) described above to between a pair of electrodes disposed in the vacuum chamber 2. The generated glow discharge decomposes a process gas supplied into the vacuum chamber 2, thereby generating a plasma. Then, the gas components produced through decomposition by the plasma are deposited on the surface of each electrode, thereby depositing a CVD coating. That is, the use of the substrate W as either of a pair of electrodes can deposit the CVD coating on the surface of the substrate W.

As shown in Figs. 1, 2, and 4A, a half of the rotation tables 4 in the plasma CVD apparatus 100 of the first embodiment belong to the first group 18 connected to one pole of the plasma generation power supply 10. Together with this, a remaining half of the rotation tables 4 belong to the second group 19 connected to the other pole of the plasma generation power supply 10. Thus, the plasma can be generated between the substrates W held by the rotation tables 4 belonging to the first group 18, and the substrates W held by the rotation tables 4 belonging to the second group 19, these groups having different polarities from each other.

Specifically, when the six rotation tables 4 in total are disposed on the revolution table 5, the three rotation tables 4 among the rotation tables 4 designated by "A" in Fig. 2 belong to the first group 18, while the three rotation tables 4 designated by "B" in Fig. 2 belong to the second group 19. That is, the number of the rotation tables 4 belonging to the first group 18 is the same as that of the rotation tables 4 belonging to the second group 19.

Specifically, as to these rotation tables 4, the rotation tables 4 belonging to the second group 19 are provided on both sides of the rotation table 4 belonging to the first group 18. Further, another rotation table 4 belonging to the first group 18 is provided adjacent to the rotation table 4 belonging to the second group 19. That is, the rotation tables 4 belonging to the first group 18 and the rotation tables 4 belonging to the second group 19 are arranged one by one in alternate order (alternately) around a revolution axis Q of the revolution table 5.

The plasma generation power supply 10 has a pair of electrodes. All three rotation tables 4 belonging to the first group 18 are connected to one electrode of the plasma generation power supply 10. All three rotation tables 4 belonging to the second group 19 are connected to the other electrode of the plasma generation power supply 10. That is, during application of the voltage, the rotation table 4 belonging to the first group 18 has constantly a polarity reverse to that of the rotation table 4 belonging to the second group 19.

The above-mentioned polarities are imparted to the respective rotation tables 4, for example, by providing a brush mechanism (not shown) in each of the revolution axis Q and a rotation axis P, and applying voltages with the respective polarities to the revolution axis Q and the rotation axis P through the brush mechanisms. The revolution axis Q and the rotation axis P are rotatably held by the bearing mechanism, through which the voltage may be applied thereto.

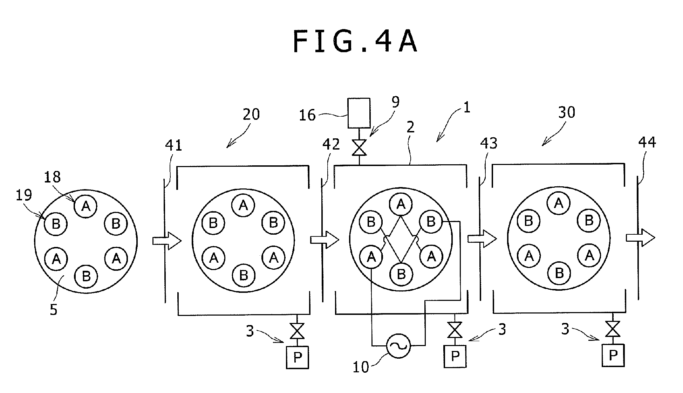

As shown in Figs. 1 and 2, in the plasma CVD apparatus 100, the six rotation tables 4 are arranged on the revolution table 5 at intervals of 60° around the revolution axis Q. Now, referring to Figs. 4A and 4B, a description will be given of the actual operation state of deposition of the CVD coating using the plasma CVD apparatus 100. Fig. 4A is a plan view of the plasma CVD apparatus 100, and Fig. 4B is a side view of the plasma CVD apparatus 100.

### (First Step: Preparation of Substrate W)

First, the substrates W are set on the rotation tables 4. The substrates W may be directly fixed to the rotation tables 4, or may be installed on the rotation tables 4 via the mounting jig 13. The rotation tables 4 constitute the substrate table together with the revolution table 5. Further, the substrate table is movable within the plasma CVD apparatus 100, while being mounted on the table trolley 50.

### (Second Step: Carrying into Load-lock Chamber 20, and Pretreatment)

After the substrate W is prepared in this way, first, the isolation valve 41 as an inlet door of the load-lock chamber 20 is opened, and then the table trolley 50 with the substrates W mounted thereon enters the load-lock chamber 20. Then, the isolation valve 41 as the inlet door of the load-lock chamber 20 is closed, and the inside of the load-lock chamber 20 is exhausted by the vacuum pump 3 serving as the vacuum exhaust means. Thereafter, the substrate W is preferably heated by a heater within the load-lock chamber 20. In this step, the isolation valve 42 is kept closed. In an example shown in Fig. 4, also in the load-lock chamber 20, like the deposition chamber 1, a rotation mechanism for the substrate table positioned at the bottom surface of the load-lock chamber 20 is raised to be coupled to the substrate table on the table trolley 50, thereby enabling rotation of the substrate table. If the rotation of the substrate table is unnecessary, the load-lock chamber 20 does not need the rotation mechanism for the substrate table.

### (Third Step: Process in Deposition Chamber 1)

Next, the isolation valve 42 between the load-lock chamber 20 and the deposition chamber 1 previously evacuated is opened, and the table trolley 50 with the substrates W mounted thereon is moved to the deposition chamber 1. After completion of the movement of the table trolley 50 to the deposition chamber 1, the isolation valve 42 is closed to evacuate the inside of the deposition chamber 1. In addition, in the first embodiment, the rotation mechanism for the substrate table positioned at a bottom part of the deposition chamber 1 is raised to be coupled to the substrate table on the table trolley 50, thereby enabling rotation of the substrate table, and simultaneously causing the substrate table to be electrically connected to the plasma generation power supply 10.

Then, the gas supply unit 9 supplies inert gas, such as Ar, or gas, such as H₂ or O₂, into the vacuum chamber 2 as needed to generate the glow discharge for cleaning the surface between the substrates W by supplying power from the plasma generation power supply 10 (ion bombardment process).

Thereafter, the gas supply unit 9 supplies the process gas into the vacuum chamber 2, thereby holding the pressure of the vacuum chamber 2 at a pressure of 0.1 to 1000 Pa appropriate for deposition.

In deposition, the glow discharge is generated between the substrates W on the rotation tables 4 belonging to the first group 18 and the substrates W on the rotation tables 4 belonging to the second group 19 by supplying AC power from the plasma generation power supply 10 to the rotation tables 4 belonging to the respective groups 18 and 19, so that a plasma required for deposition is generated between the substrates W.

An appropriate pressure during the deposition process differs depending on the kind of the CVD coating (process gas and reaction gas) to be deposited. In general, the pressure is preferably in a range of approximately 0.1 Pa to 1000 Pa. As mentioned above, the pressure in the deposition of approximately 0.1 Pa to 1000 Pa enables stable generation of the glow discharge, thereby depositing the coating at appropriate deposition rate. Further, the pressure in the deposition is preferably 100 Pa or less from the viewpoint of suppressing formation of powder together with the reaction in gas.

An AC voltage supplied from the plasma generation power supply 10 is preferably in a range of 300 V to 3000 V required for maintaining the glow discharge (as a wave crest value of the voltage between both electrodes). Further, the AC output power supplied from the plasma generation power supply 10 is preferably in a range of about 0.05 to 5 W/cm² in terms of power per unit area.

After adjusting the voltage and power of the AC current supplied from the plasma generation power supply 10 in this way, the substrate is rotated and revolved every rotation table 4, whereby the stable glow discharge is generated between the substrates W (substrates W close to each other) adjacent in the peripheral direction, which can form the CVD coating with a uniform thickness over the surfaces of the substrates W. During these steps, the isolation valve 42 and the isolation valve 43 are kept closed.

### (Fourth Step: Carrying into Load-lock Chamber 30, and Postprocessing)

When the deposition process is finished, the output from the plasma generation power supply 10 as well as the introduction of the process gas are stopped. Thereafter, the isolation valve 43 located between the deposition chamber 1 and the load-lock chamber 30 on its downstream side which is previously evacuated is opened. The substrates W mounted on the substrate table are transported to the load-lock chamber 30 by moving the table trolley 50, and then the isolation valve 43 is closed. Thereafter, the plasma CVD apparatus is brought into a standby state for a decrease in temperature of the substrate W within the load-lock chamber 30 as needed. Note that in this step, the isolation valve 44 is kept closed.

### (Fifth Step: Carrying Out of Load-lock Chamber 30)

Then, the atmospheric air, inert gas, or the like is introduced into the load-lock chamber 30. Once the pressure of the load-lock chamber 30 reaches the atmospheric pressure, the isolation valve 44 as an outlet door of the load-lock chamber 30 is opened, and the table trolley 50 with the substrates W mounted thereon departs from the load-lock chamber 30.

### (Operation State in Deposition Step)

In the deposition chamber 1, as mentioned above, the rotation tables 4 of the first group 18 and the rotation tables 4 of the second group 19 which have the reversed polarities to each other are arranged in alternate order (alternately) in the peripheral direction of the table, which generates a potential difference between the substrates W respectively held by the rotation tables 4 adjacent in the peripheral direction. Thus, the glow discharge is surely generated between both substrates. If positive and negative charges of both electrodes are switched in the plasma generation power supply 10, the polarities of the rotation tables 4 adjacent in the peripheral direction are also switched to thereby subsequently generate the glow discharge between both electrodes. Thus, the deposition can be uniformly performed on the numerous substrates W at one time.

That is, when the substrate W on the rotation table 4 belonging to the first group 18 acts as a working electrode, and the CVD coating is deposited on the side of the substrate W, the substrate W on the rotation table 4 belonging to the second group 19 acts as a counter electrode (opposite electrode). Then, when the positive and negative electrodes of the plasma generation power supply 10 are switched, the substrate W on the rotation table 4 belonging to the second group 19 acts as the working electrode, and the substrate W on the rotation table 4 belonging to the first group 18 acts as the counter electrode.

That is, with the structure described above, even though the substrates W serve as the counter electrode, the casings for the revolution table 5 and the vacuum chamber 2 do not serve as the counter electrode. Since they do not act as a discharge generation electrode, these members are not exposed directly to a plasma produced by decomposing the source gas, and thus the coating is less likely to be deposited on these members, as compared to in the related art. As a result, flakes that would cause deposition of a thick coating is less likely to occur, which hardly generates the defective coating. These members do not act as an electrode for generation of the glow discharge so as to generate a plasma. Even if an insulating coating is deposited thickly during the operation for a long time, the generation of the plasma is not made unstable. Therefore, the CVD coating with less variation in film properties and thickness can be also stably produced.

In particular, the deposition chamber 1 of the in-line plasma CVD apparatus is required to process the numerous substrates without being exposed to the atmospheric air. Thus, the structure of the plasma CVD apparatus 100 in the first embodiment is very useful because it does not deposit the thick coating on the casing of the vacuum chamber 2.

The minimum deposition process has been described above. The minimum process includes carrying in the substrate in the atmospheric state, evacuating, heating, deposition by the plasma CVD apparatus, cooling, and carrying out the substrate in the atmospheric state in this order. If necessary, a more complicated deposition process can be achieved by increasing the number of chambers in the plasma CVD apparatus 100 and the like. For example, the plasma CVD apparatus 100 can also include numerous compartments for performing different steps as follows.

1) Load-lock Chamber: Evacuation
2) Heating Chamber: Preheating of Substrate W
3) Pretreatment Chamber: Adhesion Improvement Process Including Etching of Substrate W or the like.
4) Intermediate Layer Deposition Chamber: Formation of Intermediate Layer for Improvement of Adhesion by Sputtering or the like
5) Deposition Chamber: Deposition by Plasma CVD on Substrates Divided into Two Groups
6) Cooling Chamber: Cooling
7) Load-lock Chamber: Exposure to Atmosphere

Also in this case, the structure of the plasma CVD apparatus 100 in the first embodiment can be employed in the "5) deposition chamber" to achieve the stable deposition in the deposition chamber, and a low frequency of maintenance.

### <Second Embodiment>

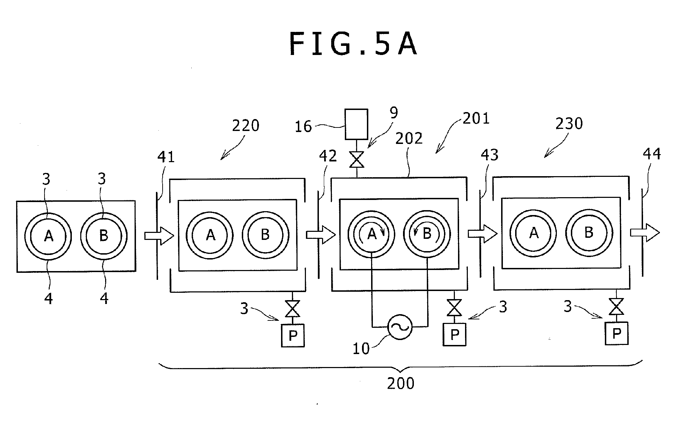

Now, a plasma CVD apparatus 200 according to a second embodiment of the invention will be described with reference to Figs. 5A to 5D. The plasma CVD apparatus 200 of the second embodiment differs from the above-mentioned plasma CVD apparatus 100 of the first embodiment in arrangement of the substrates W on the substrate table. Except for the above-mentioned point, the plasma CVD apparatus 200 of the second embodiment is the substantially same as that of the first embodiment, and thus the same parts as the above-mentioned description will not be repeated below.

Fig. 5A illustrates the plasma CVD apparatus 200 in the second embodiment. Fig. 5A corresponds to Fig. 4A.

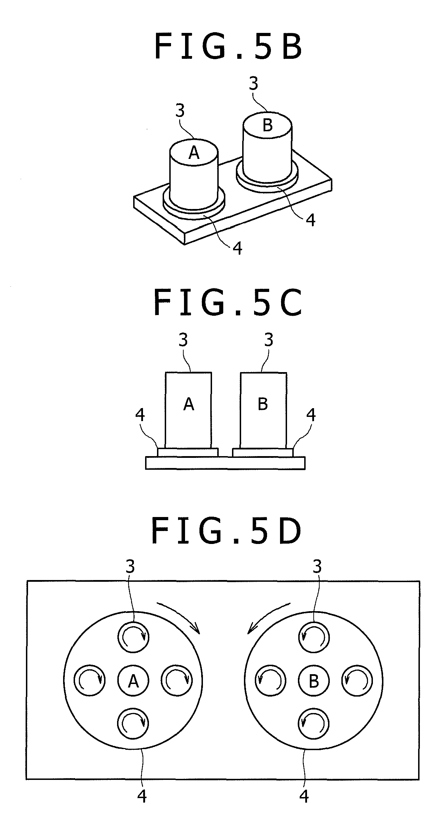

As shown in Fig. 5A, the plasma CVD apparatus 200 includes a deposition chamber 201 provided with a plasma CVD mechanism and having a vacuum chamber 202, a load-lock chamber 220 disposed on the upstream side of the deposition chamber, and a load-lock chamber 230 disposed on the downstream side of the deposition chamber. As shown in Figs. 5B and 5C, the plasma CVD apparatus 200 is provided with a pair of rotating substrate tables 4 on a table trolley. The substrates W are respectively mounted on the substrate tables 4.

The pair of substrate tables are insulated from each other, and also insulated from the vacuum chamber 202. The substrates W on each table constitute respective groups. The deposition chamber 201, the load-lock chamber 220, and the load-lock chamber 230 have the respective size that can accommodate therein the substrate table. In the deposition chamber 201, a plasma is generated between the groups of the substrates W on the substrate tables, thereby depositing a coating on the substrate W.

The substrate table may have a mechanism for planetary rotation of each substrate W as shown in Fig. 5D.

### <Third Embodiment>

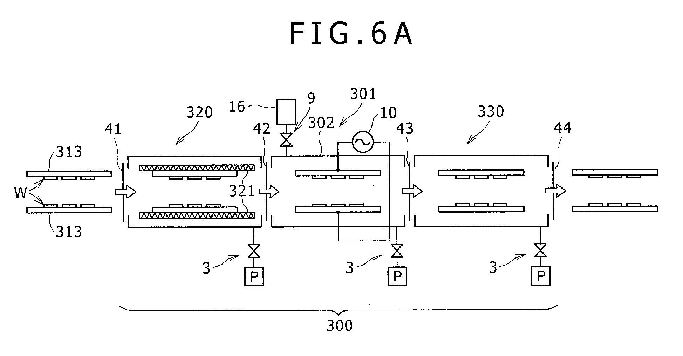

Now, a plasma CVD apparatus 300 according to a third embodiment of the invention will be described with reference to Fig. 6A. The plasma CVD apparatus 300 differs from the plasma CVD apparatus 100 of the above-mentioned first embodiment in arrangement of the substrates W. Except for the above-mentioned point, the plasma CVD apparatus 300 of the third embodiment is the substantially same as that of the first embodiment, and thus the same parts as the above-mentioned description will not be repeated below.

Fig. 6A illustrates the plasma CVD apparatus 300 in the third embodiment. Fig. 6A is a plan view explaining the operation states of the in-line plasma CVD apparatus, and corresponding to Fig. 4A.

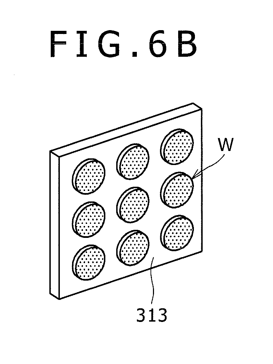

As shown in Fig. 6A, the plasma CVD apparatus 300 includes a deposition chamber 301 provided with a plasma CVD mechanism and having a vacuum chamber 302, a load-lock chamber 320 disposed on the upstream side of the deposition chamber, and a load-lock chamber 330 disposed on the downstream side of the deposition chamber. In the plasma CVD apparatus 300, at least one substrate W is mounted on each of a pair of substrate holders 313. As shown in Fig. 6B, each of the substrate holders 313 has a flat plate shape, and serves to fix and hold one or more substrates W. The substrate holder 313 illustrated in Fig. 6B has nine substrates W mounted thereon. The substrates W mounted on one substrate holder form one group.

The pair of substrate holders 313 is insulated from each other and also insulated from the vacuum chamber 302 at least in the deposition chamber 301, and thus can have potentials independent from each other. In the load-lock chamber 320, the deposition chamber 301, and the load-lock chamber 330, the pair of the substrate holders 313 are disposed to be opposed to each other. Specifically, the surfaces of the respective substrate holders 313 with the substrates W mounted, among both surfaces of each substrate holder, are disposed opposed to each other.

The pair of substrate holders 313 arranged in this way and having the substrates W mounted thereon is carried into the load-lock chamber 320, and then the inside of the load-lock chamber 320 is exhausted to vacuum. The load-lock chamber 320 is previously heated by the heater installed in the load-lock chamber 320, as needed.

After completion of predetermined evacuation or heating, the isolation valve 42 between the load-lock chamber 320 and the deposition chamber 301 is opened, and then the pair of substrate holders 313 with the substrates W mounted thereon is carried into the deposition chamber 1, and then the isolation valve 42 is closed. Thereafter, the load-lock chamber 320 is exposed again to the atmospheric air, thereby preparing reception of a next object to be processed.

The deposition on the substrate W carried into the deposition chamber 301 will be performed as follows. A process gas (deposition source gas, reaction gas, and auxiliary gas) is supplied into a space between the substrate holders 313 in the evacuated deposition chamber 301, thereby keeping the inside of the deposition chamber 301 at a predetermined pressure. In this state, an AC power with a high frequency is supplied from the AC plasma generation power supply 10 to the pair of substrate holders 313. As a result, an AC voltage is applied between the substrate groups fixed to the substrate holders 313, thereby generating the glow discharge between the substrates belonging to the two groups, that is, the pair of the substrate holders 313, whereby the coating is formed on the substrates W.

At this time, the plasma is formed mainly in a space between the substrate holders 313, so that the formed coating is unevenly distributed at a part facing the space. Thus, the coating is hardly formed on the inner surface of the deposition chamber 301. After completion of the formation of the coating, the output from the plasma generation power supply 10 is stopped to thereby terminate the introduction of the process gas. In this way, the deposition process is completed.

Then, the isolation valve 43 between the load-lock chamber 330 and the deposition chamber 301 is opened, so that the substrates W are transported from the deposition chamber 301 into the load-lock chamber 330 together with the substrate holders 313. After completion of the transportation, the isolation valve 43 between both the chambers 301 and 330 is closed, so that the deposition chamber 301 is brought again into a standby state for carrying-in of the substrates W from the load-lock chamber 20.

After cooling the substrate W for a predetermined cooling time, the load-lock chamber 330 receives the atmospheric air or inert gas introduced thereinto to be at an atmospheric pressure. Then, the isolation valve 44 is opened, so that the substrates W are carried out of the load-lock chamber 330, together with the substrate holders 313. In this way, the deposition process is completed. After closing the isolation valve 44, the load-lock chamber 330 is exhausted again to be brought into the standby state for transfer of a next lot from the deposition chamber 301.

Accordingly, the plasma CVD apparatus 300 of the third embodiment forms the coating on the substrates and the substrate holders, but hardly forms the coating on the wall surface of the deposition chamber and the like. Since the substrates and the substrate holders are carried out every lot, the formation of the coating on the deposition chamber can be kept minimum. As a result, even though the deposition is performed on the numerous lots, the deposition chamber is not polluted, which can prevent the flying of flake of the coating that would otherwise cause defects, or variation of the process accompanied by the formation of the insulating coating.

### <Fourth Embodiment>

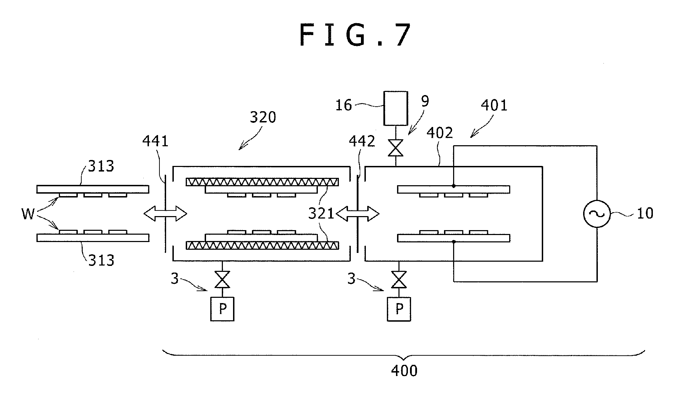

Now, a plasma CVD apparatus 400 according to a fourth embodiment of the invention will be described with reference to Fig. 7. The plasma CVD apparatus 400 of the fourth embodiment is the so-called inter-back type apparatus that is constituted by removing the load-lock chamber 330 on the downstream side from the above-mentioned plasma CVD apparatus 300 of the third embodiment. Except for the above-mentioned point, the plasma CVD apparatus 400 of the fourth embodiment is the substantially same as that of the third embodiment, and thus the same parts as the above-mentioned description will not be repeated below.

Fig. 7 illustrates the plasma CVD apparatus 400 in the fourth embodiment. Fig. 7 corresponds to Fig. 6A. The plasma CVD apparatus 400 includes a deposition chamber 401 (vacuum chamber 402) with a plasma CVD mechanism, and a load-lock chamber 320 disposed on the upstream side of the deposition chamber. Another load-lock chamber is not provided on the downstream side of the deposition apparatus 401. Thus, the deposition chamber 401 (vacuum chamber 402) does not have an opening on its downstream side.

As shown in Fig. 7, in the plasma CVD apparatus 400, after completion of the deposition process in the deposition chamber 401, the substrates W and the substrate holders 313 are reversely fed to the load-lock chamber 320 on the upstream side to be further carried out of the plasma CVD apparatus 400 in the atmospheric state.

The plasma CVD apparatus 400 has a fewer compartments as compared to the plasma CVD apparatus 300 of the third embodiment, and thus can suppress facility cost.

### <Fifth Embodiment>

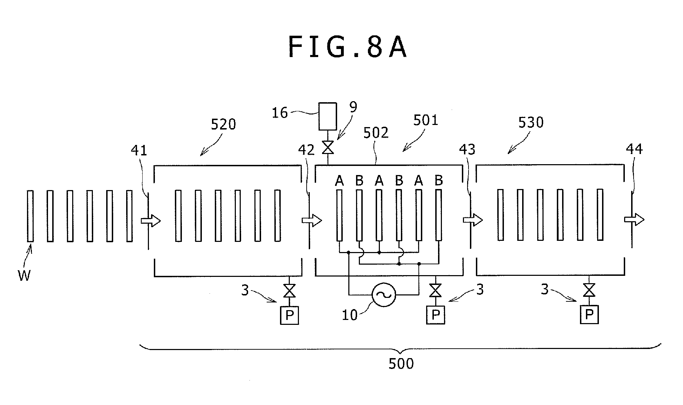

Now, a plasma CVD apparatus 500 according to a fifth embodiment of the invention will be described with reference to Fig. 8A. The plasma CVD apparatus 500 of the fifth embodiment differs from the above-mentioned plasma CVD apparatus 100 of the first embodiment in arrangement of the substrates W. Except for the above-mentioned point, the plasma CVD apparatus 500 of the fifth embodiment is the substantially same as that of the first embodiment, and thus the same parts as the above-mentioned description will not be repeated below.

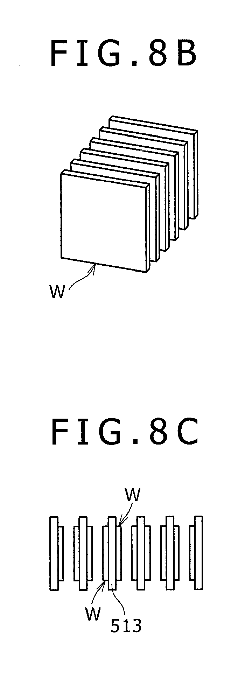

Fig. 8A illustrates the plasma CVD apparatus 500 in the fifth embodiment. Fig. 8A corresponds to Fig. 4A. The plasma CVD apparatus 500 includes a deposition chamber 501 provided with a plasma CVD mechanism and having a vacuum chamber 502, a load-lock chamber 520 disposed on the upstream side of the deposition chamber, and a load-lock chamber 530 disposed on the downstream side of the deposition chamber. In the plasma CVD apparatus 500, the substrates W having a flat or substantially flat plate shape are processed as shown in Fig. 8B. These substrates W are disposed at intervals in the form of multilayer. These substrates W are alternately divided into different groups. In other words, the substrates W arranged in the form of multilayer are electrically connected to have the same potential every other substrate, and are insulated from the substrates belonging to another group and the vacuum chamber in at least the deposition chamber 501.

In a modified example, as shown in Fig. 8C, the flat plate-shaped substrate holders 513 can be arranged at intervals in the form of multilayer, and the substrates W can be attached to both sides of each substrate holder 513.

In this way, the substrates W stacked at intervals in the form of multilayer, or the substrate holder 513 with the substrates W set thereat are carried into the plasma CVD apparatus 500.

The deposition on the substrates W carried into the deposition chamber 501 will be performed as follows. A process gas (deposition source gas, reaction gas, and auxiliary gas) is supplied into a space between the substrates W in the evacuated deposition chamber 501, or between the substrate holders 513, thereby keeping the space at a predetermined pressure. In this state, an AC power with a high frequency is supplied from the AC plasma generation power supply 10 to the substrates W, or the substrate holders 513 arranged in the form of multilayer. As a result, the AC voltage is applied between the substrates W of the group A or group B (or the substrates W fixed to the substrate holders 513), so that the glow discharge is generated between the substrates W belonging to the two groups (or between the substrate holders 513 of the two groups), thereby forming the coatings on the substrates W. In this case, a plasma is generated between the substrates W stacked in the form of multilayer (or between the substrate holders 513). Thus, the coating can be formed on both surfaces of the substrate W, or on both surfaces of the substrate holder 513.

### <Sixth Embodiment>

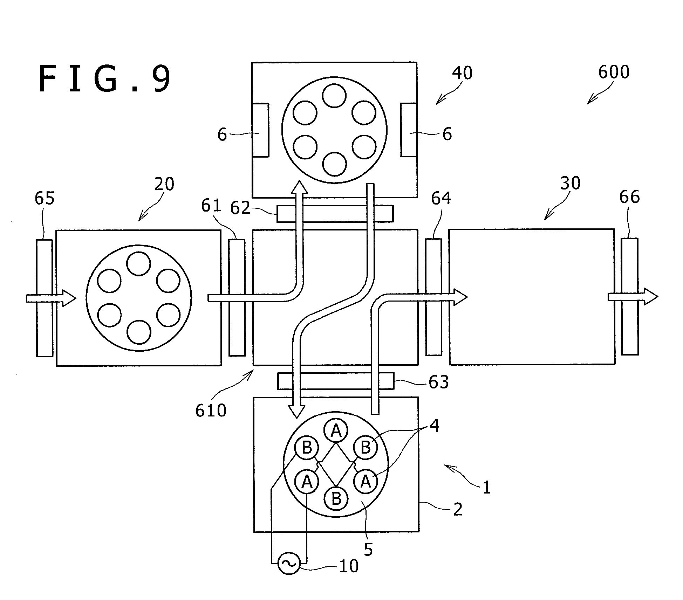

Now, a plasma CVD apparatus 600 according to a sixth embodiment of the invention will be described with reference to Fig. 9. The plasma CVD apparatus 600 of the sixth embodiment differs from the plasma CVD apparatus described in the above embodiments in arrangement of the compartments and in operation of the substrate table. Except for the above-mentioned points, the plasma CVD apparatus 600 of the sixth embodiment is the same as in other embodiments described above, and thus the same parts as the above-mentioned description will not be repeated below.

Fig. 9 illustrates a plan view of the plasma CVD apparatus 600 in the sixth embodiment. Fig. 9 corresponds to Fig. 2. The plasma CVD apparatus 600 includes a transfer chamber 610 disposed at the center thereof as seen from the above, and a plurality of chambers disposed around the transfer chamber. That is, the plurality of chambers includes the load-lock chamber 20 disposed on the upstream side, although shown on the left side of the figure, an intermediate layer deposition chamber 40 disposed on the upstream side for depositing an intermediate layer, the deposition chamber 1 disposed on the downstream side and having the vacuum chamber 2, and the load-lock chamber 30 disposed on the downstream side, although shown on the right side of the figure. The load-lock chamber 20 is provided with an isolation valve 65 serving as a door for carrying in the substrate W. The load-lock chamber 30 is provided with an isolation valve 66 serving as a door for carrying out the substrate W.

The respective isolation valves are disposed between the transfer chamber 610 and the respective chambers around the transfer chamber. Specifically, an isolation valve 61 is openably and closably provided between the transfer chamber 610 and the load-lock chamber 20. An isolation valve 62 is openably and closably provided between the transfer chamber 610 and the deposition chamber 1. An isolation valve 63 is openably and closably provided between the transfer chamber 610 and the intermediate layer deposition chamber 40. An isolation valve 64 is openably and closably provided between the transfer chamber 610 and the load-lock chamber 30. These isolation valves can maintain the transfer chamber 610, the deposition chamber 1, and the intermediate layer deposition chamber 40 in the state of evacuation during operation of the plasma CVD apparatus 600.

As shown in Fig. 9, the substrates W are mounted on the revolution table 5 with the six rotation tables 4 disposed thereon, like the first embodiment. The substrates W are carried into the load-lock chamber 20 on the upstream side from the outside of the plasma CVD apparatus 600, while being mounted on the revolution table 5. Then, the substrates W are sequentially transported to the intermediate layer deposition chamber 40, the vacuum chamber 2 of the deposition chamber 1, and the load-lock chamber 30 on the downstream side, via the transfer chamber 610. Therefore, the substrates W are carried out from the load-lock chamber 30 on the downstream side to the outside of the plasma CVD apparatus 600. The order of transport of the revolution table 5 is indicated by white arrows of Fig. 9.

The same or similar one as the table trolley 50 described in the first embodiment is used as a transport mechanism for the revolution table 5. In an example shown in Fig. 9, the substrates W are mounted on the revolution table 5 with the six rotation tables 4 arranged thereon, like the first embodiment. Alternatively, the form of the table and the mounting state of the substrate W may be the same as those of other embodiments described above.

The procedure of the deposition process for the substrate W in the plasma CVD apparatus 600 will be described below.

The deposition process by the plasma CVD apparatus 600 involves, after depositing the intermediate layer via the evacuation, another deposition by the plasma CVD, cooling, and taking out the substrate W to the atmosphere, which are performed in this order. The substrates W mounted on the revolution table 5 will be processed in the following way. In an initial state, the isolation valves 61 to 66 are closed, and the transfer chamber 610, the deposition chamber 1, and the intermediate layer deposition chamber 40 are in the vacuum state.

The isolation valve 65 is opened, and the revolution table 5 with the substrates W mounted thereon is carried into the load-lock chamber 20. Thereafter, the isolation valve 65 is closed and the inside of the load-lock chamber 20 is exhausted to vacuum.

After completion of the exhaust from the load-lock chamber 20, the isolation valves 61 and 62 are opened, and then the revolution table 5 with the substrates W mounted on is moved to the intermediate layer deposition chamber 40 via the transfer chamber 610. After completion of the movement, the isolation valve 61 is closed.

The load-lock chamber 20 is exposed to the atmosphere after closing the isolation valve 61, and then by opening the isolation valve 65, the load-lock chamber 20 is brought into a standby state for next substrates W to be carried thereinto. In the intermediate layer deposition chamber 40, a coating supply source (sputter source) 6 is operated to form an intermediate layer serving as an underlayer for the CVD layer, on the surface of each substrate W.

After completion of the deposition of the intermediate layer at the intermediate layer deposition chamber 40, the isolation valves 62 and 63 are opened, and then the revolution table 5 with the substrates W mounted on is moved to the deposition chamber 1 via the transfer chamber 610. The intermediate layer deposition chamber 40 is brought into the standby state for transfer of next substrates W from the load-lock chamber 20.

In the deposition chamber 1, after closing the isolation valve 63, the substrates W of the two groups mounted on the revolution table 5 are respectively connected to both electrodes of the plasma generation power supply 10, so that the deposition is performed while introducing the process gas.

After completion of the deposition of the CVD layer in the deposition chamber 1, the isolation valves 63 and 64 are opened, and then the revolution table 5 with the substrates W mounted thereon is moved to the load-lock chamber 30 via the transfer chamber 610. The deposition chamber 1 is brought into the standby state for transfer of next substrates W from the intermediate layer deposition chamber 40.

In the load-lock chamber 30, the substrates W of the two groups mounted on the revolution table 5 wait until they are cooled to an appropriate temperature after the isolation valve 64 is closed. After the substrates W are cooled to the appropriate temperature, the atmospheric air is introduced into the load-lock chamber 30, and the isolation valve 66 is opened, so that the revolution table 5 with the substrates W mounted thereon is carried out of the load-lock chamber 30.

As mentioned above, the plasma CVD apparatus 600 forms the CVD coating on the substrates W and the revolution table 5, but hardly forms the CVD coating on the wall surface and the like of the deposition chamber 1. Since the substrates W and the substrate holders are carried out to the outside of the plasma CVD apparatus 600 every lot, the formation of the coating on the deposition chamber 1 can be kept minimum. As a result, even though the deposition is performed on the numerous lots, the deposition chamber 1 is not polluted, which prevents the flying of flake of the coating that would otherwise cause defects, or variation of the process accompanied by the formation of the insulating coating. In particular, the plasma CVD apparatus 600 can perform a continuous deposition process while maintaining the deposition chamber 1 in the vacuum state, thereby effectively processing the numerous lots to suppress the pollution of the deposition chamber 1. This is a very effective means for stably operating the plasma CVD apparatus 600 for a long time.

### (Seventh Embodiment)

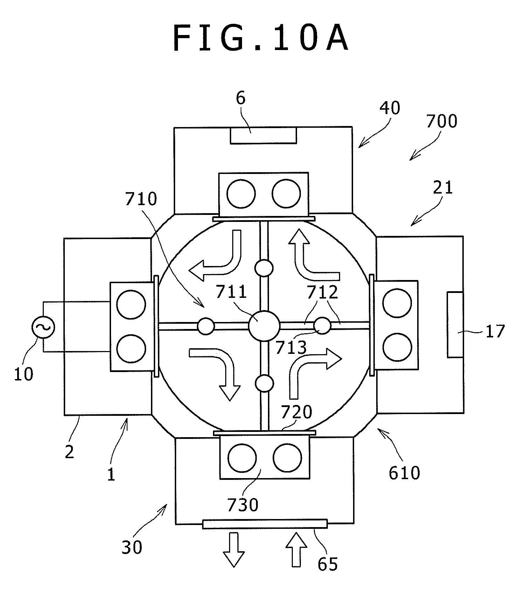

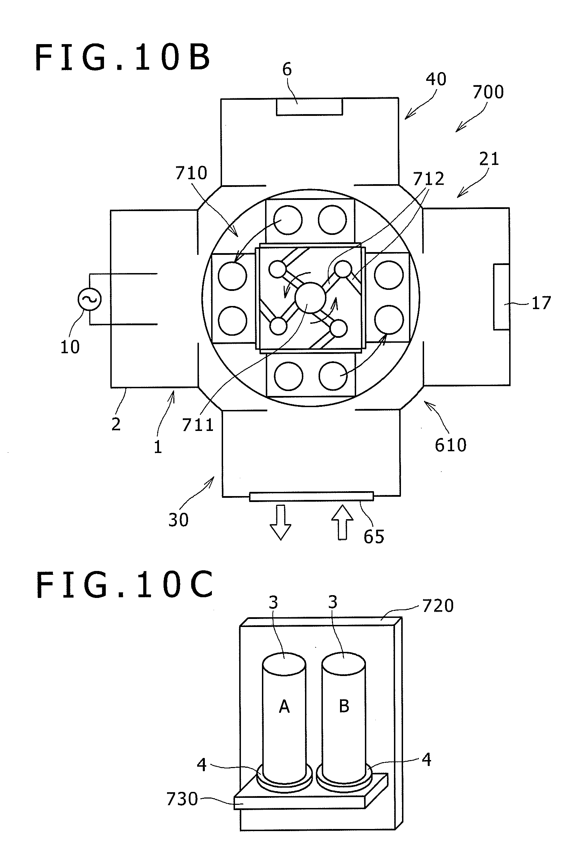

Now, a plasma CVD apparatus 700 according to a seventh embodiment of the invention will be described with reference to Figs. 10A and 10B. The plasma CVD apparatus 700 of the seventh embodiment differs from the above-mentioned plasma CVD apparatuses of the above-mentioned embodiments in arrangement of the compartments and operation of the substrate table. Except for the above-mentioned point, the plasma CVD apparatus 700 in the seventh embodiment is the substantially same as that in each of other embodiments described above, and thus the same parts as the above-mentioned description will not be repeated below.

Figs. 10A and 10B illustrate the plasma CVD apparatus 700 in the seventh embodiment. Fig. 10A is a plan view showing the state in which the processing is performed in a compartment by extending arms 712 of a rotation transport mechanism 710 to be described later. Fig. 10B is a plan view showing the state in which the substrates W are transported by being rotated from one compartment to another by shrinking the arms 712. Fig. 10C is a perspective view showing a partition plate 720 and a table 730 which are attached to the tip end of the arm 712.

As shown in Figs. 10A and 10B, the plasma CVD apparatus 700 includes the transfer chamber 610 disposed at the center thereof, and a plurality of compartments disposed around the transfer chamber, like the plasma CVD apparatus 600 of the sixth embodiment. Specifically, as seen from above the plasma CVD apparatus 700, the transfer chamber 610 is disposed at the center thereof; a heating chamber 21 is disposed at the periphery of the transfer chamber on the right side of the figure, or on the upstream side; the intermediate layer deposition chamber 40 for depositing the intermediate layer is disposed on the upper side; the vacuum chamber 2 of the deposition chamber 1 is disposed on the left side, or on the downstream side; and the load-lock chamber 30 is disposed on the lower side. The load-lock chamber 30 is provided with the isolation valve 65 serving as a door for carrying in and out the substrates W. The arrangement of the compartments or the like in the plasma CVD apparatus 700 differs from that of the plasma CVD apparatus 600. Further, the plasma CVD apparatus 700 also differ from the plasma CVD apparatus 600 in the following structural points.

The transfer chamber 610 is provided with the rotation transport mechanism 710, unlike the plasma CVD apparatus 600. The rotation transport mechanism 710 includes a rotatable central shaft 711, and four extensible arms 712 disposed around the shaft at intervals of 90°. The partition plate 720 is attached to the tip end of each arm 712. As shown in Fig. 10A, the respective arms 712 are extended, so that the respective partition plates 720 can close openings of the four compartments to set the respective four compartments in independent atmospheres. Further, the partition plate 720 is provided with the table 730 that is capable of mounting the substrates W thereon. As shown in Fig. 10B, with the arms 712 shrinking, the four partition plates 720 and the tables 730 can be moved, while rotating about the central shaft 711 (rotational movement in an anticlockwise direction as shown in Fig. 10).

As shown in Fig. 10C, the substrates W are mounted on the table 730 with the two rotation tables 4 disposed thereon. The substrates W are mounted on the rotation tables 4 placed on the table 730, and carried into the load-lock chamber 30 from the outside of the plasma CVD apparatus 600. The substrates W are transported from the heating chamber 21 to the intermediate layer deposition chamber 40, the deposition chamber 1 (vacuum chamber 2), and then the original load-lock chamber 30 in this order by the rotation transport mechanism 710 provided in the transfer chamber 610. Finally, the substrates W are carried out of the load-lock chamber 30 to the outside of the plasma CVD apparatus 700. The order of transport of the revolution table 5 is indicated by white arrows of Fig. 10A.

In the present embodiment, the two rotation tables 4 are arranged on the table 730, and each rotation table 4 has the substrate W mounted thereon. However, alternatively, the form of the table and the mounting state of the substrate W may be the same as those of other embodiments described above.

The procedure of the deposition process for the substrate W in the plasma CVD apparatus 700 will be described below. The deposition process in the plasma CVD apparatus 700 involves evacuation, heating, deposition of the intermediate layer, deposition by the plasma CVD, cooling, and taking out the substrate to the atmosphere, which are performed in this order in the same way as that in the plasma CVD apparatus 600. The substrates W mounted on the table 730 are processed as follows. Fig. 10A shows an initial state. In the initial state, the isolation valve 65 is in a closed state, and the substrates W already subjected to the deposition process are present in the load-lock chamber 30.

The atmospheric air is introduced into the load-lock chamber 30, while the load-lock chamber 30 is independently separated from other compartments by the partition plate 720. Thereafter, the isolation valve 65 is opened to expose the inside of the load-lock chamber 30 to the atmospheric air, so that the substrates W subjected to the deposition process are taken out of the table 730. Then, next substrates W mounted on the table 730 are carried into the load-lock chamber 30. Thereafter, the isolation valve 65 is closed and the inside of the load-lock chamber 30 is exhausted to vacuum.

After completion of the exhaust from the load-lock chamber 30, the central shaft 711 rotates by 90° in the anticlockwise direction with the arms 712 of the rotation transport mechanism 710 shrinking. After end of the rotation, the arms 712 of the rotation transport mechanism 710 are extended to transport the table 730 into the heating chamber 21. At this time, the partition plate 720 makes the heating chamber 21 independent from other compartments (with all four compartments made independent from each other). Thereafter, a heater 17 disposed in the heating chamber 21 heats the substrates W by increasing its temperature, while rotating the rotation table 4.

When the heating of the substrates W in the heating chamber 21 is completed, the central shaft 711 rotates by 90° in the anticlockwise direction with the arms 712 of the rotation transport mechanism 710 shrinking. After end of the rotation, the arms 712 of the rotation transport mechanism 710 are extended to transport the table 730 into the intermediate layer deposition chamber 40. At this time, the partition plate 720 makes the intermediate layer deposition chamber 40 independent from other compartments. Thereafter, the coating supply source (sputter source) 6 is operated while rotating the rotation table 4 to form the intermediate layer serving as an underlayer for the CVD layer, on the surface of each substrate W.

Once the deposition of the intermediate layer in the intermediate layer deposition chamber 40 is completed, the central shaft 711 rotates by 90° in the anticlockwise direction with the arms 712 of the rotation transport mechanism 710 shrinking. After end of the rotation, the arms 712 of the rotation transport mechanism 710 are extended to transport the table 730 into the deposition chamber 1. At this time, the partition plate 720 makes the deposition chamber 1 independent from other compartments. Thereafter, the substrates W belonging to the two groups are respectively connected to both electrodes of the plasma generation power supply 10, while the rotation tables 4 are rotating. In this way, the deposition is performed while introducing the process gas.

After completion of the deposition of the CVD layer in the deposition chamber 1, the central shaft 711 rotates by 90° in the anticlockwise direction with the arms 712 of the rotation transport mechanism 710 shrinking. After end of the rotation, the arms 712 of the rotation transport mechanism 710 are extended to transport the table 730 into the load-lock chamber 30. At this time, the partition plate 720 makes the load-lock chamber 30 independent from other compartments. Thereafter, the substrates W of the two groups wait until they are cooled to the appropriate temperature. After the substrates W are cooled to the appropriate temperature, the atmospheric air is introduced into the load-lock chamber 30, and the isolation valve 65 is opened, so that the substrates W are carried out of the load-lock chamber 30.

In this way, the deposition process (which involves evacuation, heating, deposition of the intermediate layer, deposition of the CVD layer by the plasma CVD, and cooling) is performed with the isolation valve 65 closed while all four compartments are in the vacuum state. When the arms 712 shrinks in this state, the four partition plates 720 are drawn into the center of the transfer chamber 610 with the substrate W mounted on the tables 730. In this state, the central shaft 711 can rotate by 90° in the anticlockwise direction. Thereafter, once the arms 712 are extended, the respective substrates W can be transported to the compartment to be subjected to next processing of the deposition process.

This kind of deposition process can also be simultaneously performed on the substrates W accommodated in the respective four compartments. In this way, the process efficiency can be drastically improved.

As mentioned above, the plasma CVD apparatus 700 hardly forms the CVD coating on the wall surface or the like of the deposition chamber 1, and thus can keep the formation of the coating on the deposition chamber 1 minimum, like the plasma CVD apparatus 600. As a result, even though the deposition is performed on the numerous lots, the deposition chamber 1 is not polluted or contaminated, which prevents the flying of flake of the coating that would otherwise cause defects, or variation of the process accompanied by the formation of the insulating coating. In this way, the pollution of the deposition chamber 1 can be suppressed, which is very effective for stably and effectively operating the plasma CVD apparatus 700 for a long time.

Note that the number of compartments disposed is changed depending on the number of process steps, and a rotation angle per one rotation by the rotation transport mechanism 710 is also changed.

The present invention is not limited to each embodiment described above, and various modifications and changes can be appropriately made to the shape, structure, and material of the respective components, and the combination thereof without changing the spirit of the invention. In the present embodiments disclosed, the features not definitely disclosed, for example, operating conditions, process requirements, various parameters, size, weight, and volume of components, and the like do not depart from the range that can be normally implemented by a person skilled in the art. Thus, those features can be easily made by a normal person skilled in the art.

Accordingly, the present invention can provide the in-line plasma CVD apparatus with a high production efficiency that is less likely to deposit a CVD coating on a part other than a substrate, thereby being capable of stably performing its operation without cleaning for a long time. The in-line plasma CVD apparatus includes the deposition chamber and a compartment other than the deposition chamber. The substrate is conveyed between the deposition chamber and the compartment. The deposition chamber includes a vacuum chamber, a pump for exhausting the air from the vacuum chamber, a gas supply unit for supplying a source gas into the vacuum chamber, and an AC plasma generation power supply for generating a plasma in the source gas supplied into the vacuum chamber. In the deposition chamber, the substrates are divided or classified into two groups. Specifically, the substrates belong to either a first group which is connected to one pole of the plasma generation power supply, or a second group which is connected to the other pole of the plasma generation power supply.

In the invention, preferably, the substrates of the two groups can be configured to be flat plate-shaped substrates opposed to each other.

Further preferably, the substrates of the two groups are flat plate-shaped substrates fixed onto holders alternately arranged at intervals. Alternatively, the substrates of the two groups are flat plate-shaped substrates alternately arranged at intervals, and the substrates of the two groups or the substrate holders can be configured to alternately belong to groups different from each other.

Further preferably, the substrates of the two groups can be configured to be mounted on the substrate holders that respectively rotate during the deposition process.

Further preferably, the substrates of the two groups can be configured to be mounted on the substrate holders that respectively rotate and revolve during the deposition process.

Further preferably, the substrates of the two groups are mounted on the substrate holders that rotate and revolve. The number of the rotation tables belonging to the first group is set to the same as that of the rotation tables belonging to the second group. The rotation tables of the first group and the rotation tables of the second group can be configured to be alternately arranged one by one around the revolution axis.

## Claims

1. An in-line plasma CVD apparatus, comprising:
a deposition chamber; and a compartment other than the deposition chamber, wherein a substrate is conveyed between the deposition chamber and the compartment, and a coating is deposited on the substrate,
the deposition chamber comprising:
a vacuum chamber;
a pump for exhausting air from the vacuum chamber;
a gas supply unit for supplying a source gas into the vacuum chamber; and
an AC plasma generation power supply for generating a plasma in the source gas supplied into the vacuum chamber, wherein:
the substrates in the deposition chamber are divided into two groups, and each of the substrates belongs to either of the two groups, the two groups including a first group connected to one pole of the plasma generation power supply, and a second group connected to the other pole of the plasma generation power supply.

2. The plasma CVD apparatus according to claim 1,
wherein the substrates of the two groups are flat plate-shaped substrates opposed to each other.

3. The plasma CVD apparatus according to claim 1,
wherein the substrates of the two groups are flat plate-shaped substrates fixed onto holders alternately arranged at intervals, or are flat plate-shaped substrates alternately arranged at intervals, and
the substrates of the two groups or the substrate holders alternately belong to groups different from each other.

4. The plasma CVD apparatus according to claim 1,
wherein the substrates of the two groups are mounted on substrate holders that respectively rotate during the deposition.

5. The plasma CVD apparatus according to claim 1,
wherein the substrates of the two groups are mounted on substrate holders that respectively rotate and revolve during the deposition.

6. The plasma CVD apparatus according to claim 1,
wherein the substrates of the two groups are mounted on the substrate holders that rotate and revolve,
the number of rotation tables belonging to the first group is set to the same as that of rotation tables belonging to the second group, and
the rotation tables of the first group and the second group are alternately arranged one by one around the revolution axis.
